# EUROPÄISCHE PATENTSCHRIFT

(11) **EP 1 628 511 B1**
(45) Veröffentlichungstag und Bekanntmachung des Hinweises auf die Patenterteilung: **25.03.2009**
(21) Anmeldenummer: 05016596.8
(22) Anmeldetag: 29.07.2005
(51) Int. Cl.: H05K 3/36, H01R 9/03

(54) **Baugruppe für elektrische / elektronische Geräte**
Module for electrical or electronic device
Module pour appareillage électrique ou électronique

(30) Priorität: 29.07.2004 DE 102004036858
(43) Veröffentlichungstag der Anmeldung: 22.02.2006
(73) Patentinhaber: Muck, Siegfried, 87437 Kempten (DE)
(72) Erfinder: Muck, Siegfried, 87437 Kempten (DE)
(74) Vertreter: Petra, Elke

(56) Entgegenhaltungen:
- EP-A- 0 226 086
- EP-A- 1 283 664
- EP-A- 1 480 291
- US-A- 5 148 962
- US-A- 5 190 473
- US-A- 5 482 200

## Beschreibung

Die Erfindung bezieht sich auf eine Baugruppe für elektrische/elektronische Gerätegemäß Oberbegriff des Anspruchs 1 und auf ein Verfahren zur Herstellung der Baugruppe gemäß Anspruch 10.

Eine mit einer derartigen Baugruppe vergleichbare Baugruppe geht aus der DE 101 38583 A1oder der EP 1283 664 A2 hervor. In dieser Druckschrift, nach der das Bauteil beispielsweise durch einen Festleiter oder eine Leiterplatte realisiert sein kann, ist ein Flachleiter und ein Verfahren zur Herstellung einer Lötverbindung mit demselben beschrieben. Der Flachleiter umfasst einen zu einer Seite des Flachleiters hin aufgebogenen Randbereich, der auf der gegenüberliegenden Seite einen lötbaren, elektrisch leitenden und mit mindestens einer Leiterbahn des Flachleiters verbundenen Kontaktbereich aufweist. Zum Verlöten werden die Kontaktbereiche des Flachleiters und eines Bauteils so positioniert, dass sich der aufgebogene Randbereich gegenüber dem Kontaktbereich des Bauteils befindet und von diesem wegweist. Beide Teile werden durch einen beheizten Stempel, der die Kontaktbereiche nahe dem aufgebogenen Randbereich umgibt, aufeinandergepresst und damit gegeneinander fixiert. Mittels einer Wärmequelle wird aus einem im Kontaktbereich des Bauteils befindlichen Lotdepot flüssiges Lot erzeugt, durch das die Kontaktbereiche auf Löttemperatur gebracht werden.

Nachteilig bei dieser bekannten Baugruppe ist, dass sich unterhalb des Andrückstempels zwischen dem aufgebogenen Randbereich des Flachleiters und dem planen Kontaktbereich des Bauteils die Bildung eines sich verjüngenden, engen Spalts nicht immer vermeiden lässt. Es besteht die Möglichkeit, dass das Lot in diesen umlaufenden Spalt eindringt und durch die Kapillarwirkung in den Randbereich des Lötpunktes, die an der fertigen Baugruppe erkennbare Lötstelle, kriecht, wodurch der Lötpunkt unerwünschte Ausmaße annimmt. Sofern dieser Randbereich wegen der von der Mitte des Lötpunktes ausgehenden Energiezufuhr nicht genügend vorgewärmt wird, dringt das flüssige Lot aufgrund der Kapillarwirkung des Spaltes in unregelmäßigem Ausmaß ein, so dass der Lötpunkt einen ausgefransten Randbereich erhält, der anfällig ist für die Ausbildung von mikroskopisch feinen Rissen. Diese haben die Tendenz, sich aufgrund mechanischer oder thermischer Belastungen der Bauteile auszubreiten. Die Lebensdauer der Lötverbindung wird dadurch erheblich herabgesetzt. Ferner kann nicht ausgeschlossen werden, dass sich flüssiges Lot unkontrolliert über die Kontaktbereiche hinaus ausbreitet und Ursache für Kurzschlüsse zwischen den Kontaktbereichen nahe benachbarter Leiterbahnen ist. Und nicht zuletzt weist die so hergestellte Baugruppe einen ungenügenden Berührungsschutz sowie ein unästhetisches Aussehen auf, da die Abdeckfolie des Flachleiters im Kontaktbereich entfernt werden muss, um die zum Aufschmelzen des Lotes benötigte Wärmeenergie zuführen zu können. Um zur Vermeidung dieser Nachteile eine ausreichende Vorwärmung des Randbereiches zu erzielen, muss die Dauer der Wärmezufuhr ausgedehnt werden. In diesem Fall besteht allerdings die Gefahr, dass die Abdeckfolie des Flachleiters durch übermäßige Wärmeeinwirkung geschädigt wird.

Aus der EP 0 226 086 A2 und der DE 35 44 125 C3 ist ein Steckverbinder bekannt, bei dem jeweils ein Flachkabelstück als Anschlusselement (Anschlussfuß) mit einem zugehörigen Anschlusspunkt der Leiterplatte durch Dampfphasen-Löten oder Reflow-Löten verbunden wird. Dieses kann jedoch zur Beschädigung des Flachbandleiters, insbesondere seiner Trägerfolie führen.

Die **Aufgabe** der Erfindung besteht somit darin, eine Baugruppe oben genannter Gattung zu schaffen, die so ausgestaltet ist, dass die Lötverbindungen hinsichtlich ihrer Qualität und ihres Aussehen verbessert werden. Gleichzeitig soll ein sicheres und einfaches Verfahren zur Herstellung einer solchen Baugruppe mit einem geringen Energieaufwand angegeben werden.

Gelöst wird diese Aufgabe dadurch, dass das mindestens eine Bauteil der Baugruppe insbesondere ein Kontaktstift ist, im Kontaktbereich als Hohlkörper ausgebildet ist, der einen der Leiterbahn zugewandten Boden besitzt, wodurch dieser, bei hinreichender Festigkeit eine minimierte Wärmekapazität aufweist und dass die Ausformung der Leiterbahn eine sich in Richtung zum Lotdepot verjüngende Ausbildung hat, wodurch vor Beginn des Lötvorganges ein im Wesentlichen punktförmiger Kontakt zwischen der Ausformung und dem Lotdepot vorhanden ist. Infolge der Minimierung seiner Wärmekapazität im Kontaktbereich nimmt das Bauteil während der Erwärmung auf die vorgegebene Temperatur nur einen sehr geringen Anteil der Energie auf, die die Wärmequelle für die Initiierung des Lötvorganges zur Verfügung stellt. Die Minimierung selbst kann durch extreme Verringerung der Masse des Kontaktbereiches und! oder durch Verwendung eines geeigneten Materials für den Kontaktstift erreicht werden. Der andere Anteil der Energie wird daher ohne wesentlichen Zeitverzug an das Lotdepot weitergeleitet, um dieses anzuschmelzen. Da, solange das Lotdepot noch nicht geschmolzen ist, die Ausformung einen im Wesentlichen punktförmigen Kontakt mit dem Lotdepot hat, muss an dieser sehr kleinen Übergangsfläche eine nur ebenso kleine Fläche der Ausformung auf die zum Aktivieren notwendige Temperatur erwärmt werden. Mit zunehmendem Aufschmelzen des Lotdepots und entsprechendem Eindringen der Ausformung in die Schmelze vergrößert sich diese Übergangsfläche. Durch eine entsprechende Steuerung der Wärmequelle kann die Temperatur des Lotes der augenblicklichen Situation angepasst werden, so dass die Trägerfolie der Leiterbahn nicht geschädigt wird. Der sich zur Mitte des Lötpunktes hin verjüngende, kapillarwirkende Spalt bewirkt nun, dass die Schmelze zur Lötpunktmitte hin und somit zu den am höchst erwärmten Kontaktteilen kriecht Dadurch bildet sich im Randbereich des Lötpunktes, also an der kritischen Randzone, eine geschlossene, glatte Oberfläche des umlaufenden Lotes, der Meniskus. Da von einem solchen praktisch keine Rissbildungsgefahr ausgeht, ist die hergestellte Baugruppe sowohl hinsichtlich ihres Aussehens als auch ihrer Lebensdauer wesentlich verbessert.

Dadurch dass der Kontaktbereich des Bauteils als Hohlkörper ausgebildet ist, der einen der Leiterbahn zugewandten Boden mit einer einen minimalen Energieaufwand für den Lötvorgang ermöglichenden Dicke aufweist, ist diese Ausgestaltung des Kontaktbereiches mit einem doppelten Vorteil verbunden. Zum einen kann das Wärmeaufnahmevermögen eines solchen Hohlkörpers sehr gering sein, insbesondere, wenn dessen Wand- und Bodendicke so gering gehalten wird, \vie mit Blick auf die erforderliche Biege- und Torsionsfestigkeit an der Übergangsstelle zum übrigen stabförmigen Teil des Kontaktstiftes zu vertreten ist. Zum anderen ist der Querschnitt, über den Wärme aus dem Hohlkörper in den stabförmigen Teil des Kontaktstiftes fließen kann, ebenfalls sehr gering. Damit kann nicht nur die Menge des Lotdepots im Kontaktbereich, sondern auch die zum indirekten Aufschmelzen des Lotdepots erforderliche Energie reduziert werden. Der Zeitbedarf zum Aufschmelzen wird somit verkürzt und die Regelung der für das Lötergebnis entscheidenden Temperaturkennlinie erleichtert.

Sinnvoll ist , dass der Hohlkörper durch eine Einprägung gebildet ist, die von der der Leiterbahn des Flachbandleiters abgewandten Seite eingebracht ist. Damit ist es möglich, die Energie zum Aufschmelzen des Lotdepots von der Bauteileseite einzubringen. Die auf der gegenüber liegenden Seite befindliche Trägerfolie des Flachbandleiters wird so keinen zu hohen Temperaturen ausgesetzt und bleibt damit unbeschädigt erhalten.

Auch ist vorteilhaft, dass zumindest ein Teil des Bodens durch das Lotdepot gebildet ist und der Boden mit einem mit dem Lotdepot aufgefüllten Durchbruch versehen ist. Damit kann ein bedeutender Teil des Bodens durch das Lotdepot selbst gebildet werden, ohne dass die Steifigkeit des Kontaktbereiches hin zum Stab des Kontaktstiftes wesentlich darunter leidet. Einher geht damit eine Verringerung der Masse des Hohlkörpers, so dass ein größerer Anteil der zugeführten Energie für die direkte Erwärmung des Lotdepots zur Verfugung steht. Hieraus resultiert ein schnelleres Aufschmelzen des Lots, eine Reduzierung der zum Aufschmelzen des Lots erforderlichen Energie und eine verbesserte Regelung der Temperaturkennlinie durch direkte Temperaturerkennung des Lots über ein Pyrometer.

Nach einer weiteren Ausgestaltung der Erfindung weist der Boden des Hohlkörpers eine vom Typ des angelöteten Flachbandleiters abhängige Dicke auf, wobei die Dicke des Bodens beträgt:
- bei einem FPC-Flachbandleiter mit einer Leiterbahndicke von ca. 5 bis 50 µm etwa 50 bis 250 µm,
- bei einem FFC-Flachbandleiter mit einer Leiterbahndicke von ca. 100 bis 250 µm etwa 500 µm und
- bei einem FFC- Flachbandleiter mit einer Leiterbahndicke von ca. 250 bis 500 µm etwa 1000 µm.

In vorteilhafter Weise entspricht die Wandstärke des Hohlkörpers zumindest annähernd der Dicke des Bodens. Für ein optimales Lötergebnis ist die annähernd gleiche Temperatur der zu verbindenden Teile von besonderer Wichtigkeit. Deshalb ist eine annähernd gleiche Wärmekapazität für beide zu verbindenden Teile des Kontaktpunktes anzustreben. Nachdem der Kontaktbereich der Leiterfolie nur über die Kontaktierung mit dem Lotdepot erwärmt werden kann und damit als letztes Glied in der Erwärmungskette steht, ist der Boden als Träger des Lotdepots in der Ausbildung seiner Wärmekapazität etwas höher zu dimensionieren. Die vorgeschlagenen Dicken für den Boden des Hohlkörpers ermöglichen also eine optimale Steuerung des Lötvorganges.

In weiterer Ausbildung besitzt die sich in Richtung zum Lotdepot verjüngende Ausformung der Leiterbahn vorzugsweise eine kegel- oder kugelkalottenförmige Gestalt. Eine derartige Ausbildung der Ausformung ermöglicht eine gesteuerte Erwärmung aller an dem Lötvorgang beteiligten Teile und eine optimal ablaufende Meniskusbildung durch das geschmolzene Lot. Des Weiteren verhindert diese Ausgestaltung mikroskopische Rissbildungen, vor allem, wie sie von flächigen Berührungen her bekannt sind. Ebenso wird durch eine dabei stattfindende langsame Verdrängung des geschmolzenen Lotes und der dabei zentrisch gleichmäßigen Erwärmung des Kupfer-Laminats eine Lunkerbildung weitestgehend verhindert.

Vorteilhaft ist des weiteren dass rund um den Fuß der Ausformung ein Randbereich verläuft, der in den Lötvorgang mit einbezogen ist und durch eine Randzone begrenzt ist, die durch die geometrische Gestalt der Leiterbahn begrenzt ist und in ihrer Größe ungefähr der Kontaktfläche des Hohlkörpers entspricht und dass bis hin zur Lötpunktmitte ein umlaufender, konkaver Meniskus, der den gesamten aktivierten Randbereich bis zur Randzone umfaßt wodurch sichergestellt ist, dass sich an der Lötstelle keine Mikrorisse ausbilden können.

Die Aufgabe wird auch durch ein Lötverfahren zur Herstellung einer elektronischen Baugruppe mit den Merkmalen des Anspruchs 10 gelöst. Demgemäß führt dieses Lötverfahren bei Befolgung der Verfahrensschritte zu einem Produkt, das hinsichtlich seines ästhetischen Eindruckes und der Qualität seiner Lötstellen unübertroffen ist. Die Trägerfolie der Leiterbahn bleibt im Kontaktbereich, also auch hinter der Ausformung, erhalten und bietet somit einen Berührungsschutz. Nachdem die Leiterbahn und insbesondere deren Trägerfolie in der Erwärmungskette das letzte Glied darstellt, die Trägerfolie also nur durch Kontakt der Leiterbahn mit der Schmelze des Lotes auf der der Trägerfolie gegenüberliegenden Seite erwärmt wird, wird die Trägerfolie nur gering und zeitlich so kurz erwärmt, dass diese unbeschädigt bleibt und die angelötete Leiterbahn einen temperaturunbelasteten Eindruck macht. Da durch die Ausbildung des Meniskus eine sauber abgegrenzte Lötstelle realisiert wird, ist die Gefahr einer Ausbildung und Ausbreitung von Rissen, die die Lebensdauer der Lötstellen unkalkulierbar herabsetzen, sehr gering.

Aus Gründen einer guten Steuerbarkeit der Wärmezufuhr zum Lotdepot ist es ferner vorteilhaft und sinnvoll, wenn die für den Lötvorgang benötigte Wärmeenergie von einem Laser geliefert wird.

Die Erfindung wird nachfolgend anhand zweier Ausführungsbeispiele unter Bezug auf die Zeichnung näher erläutert. Es zeigen:
- Fig. 1:: den Kontaktbereich am Ende eines Kontaktstiftes mit der auf dem ungeschmolzenen Lotdepot aufliegenden Ausformung einer Leiterbahn,
- Fig. 2:: den Kontaktbereich gemäß Fig. 1 mit der in das teilweise aufgeschmolzene Lotdepot eingedrungenen Ausformung einer Leiterbahn,
- Fig. 3:: den Kontaktbereich gemäß Fig. 1 mit der in das vollständig aufgeschmolzene Lotdepot eingedrungenen Ausformung einer Leiterbahn,
- Fig. 4:: ein Diagramm des Temperaturverlaufes des Lotes während des Lötvorganges,
- Fig. 5:: ein weiteres Ausführungsbeispiel eines Kontaktbereiches am Ende eines Kontaktstiftes mit der auf dem ungeschmolzenen Lotdepot aufliegenden Ausformung einer Leiterbahn, und
- Fig. 6:: den Kontaktbereich gemäß Fig. 5 mit der in das vollständig aufgeschmolzene Lotdepot eingedrungenen Ausformung einer Leiterbahn.

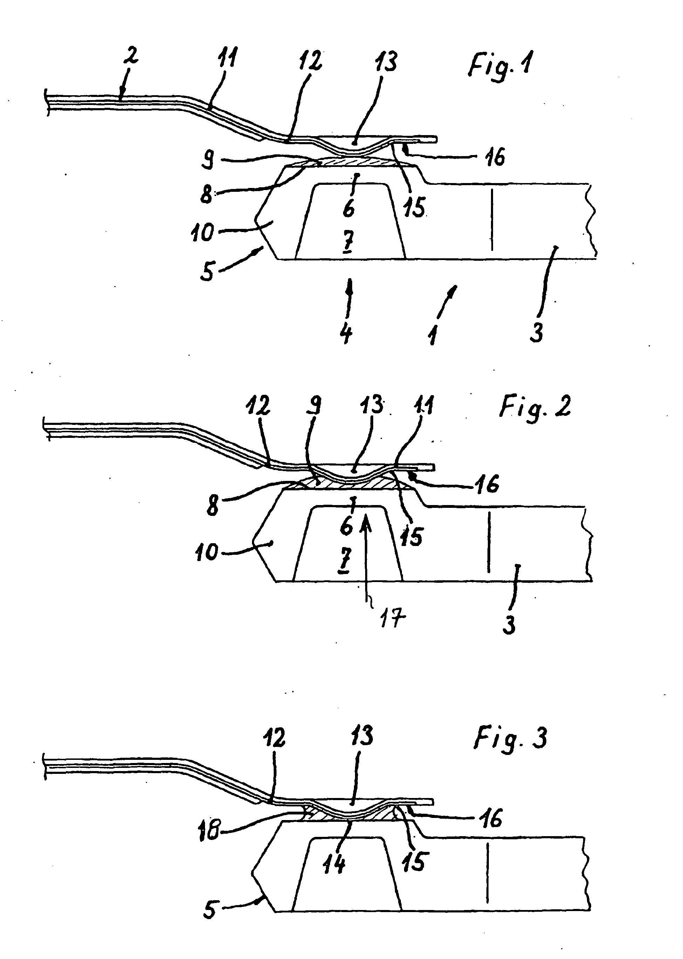

Fig. 1 bis 3 zeigen den erfindungswesentlichen Bereich einer aus einem Kontaktstift 1 und einem Flachbandleiter 2 herzustellenden Baugruppe in 3 Phasen ihrer Herstellung. Der Kontaktstift 1 weist einen Schaft 3 mit einer an seinem rechten Endbereich befindlichen, nicht gezeigten Einpresszone und einen an seinem linken Endbereich angeformten Kontaktbereich 4 auf. Der Kontaktbereich 4 ist als durch einen Prägevorgang entstandener Hohlkörper 5 mit einem belassenen Boden 6 ausgebildet. Die bei dem Prägevorgang eingebrachte Vertiefung 7 besitzt einen runden Querschnitt und weist direkt am Boden 6 einen Durchmesser auf, der im Vergleich zur Kontaktfläche 8 oberhalb des Bodens 6, die mit einem Lotdepot 9 mit sphärischer Oberfläche belegt ist, möglichst groß ist, damit die beim Lötvorgang zugeführte Wärme großflächig aufgenommen und weitergeleitet wird. Der Boden 6 und die Wand 10 des Hohlkörpers 5 sind unter Einhaltung der nötigen Festigkeit des Kontaktbereiches 4 möglichst dünn gehalten, damit dessen Wärmekapazität gering und so sichergestellt ist, dass ein sehr geringer Anteil der beim Lötvorgang aufzuwendenden Energie für die Erwärmung des Kontaktbereiches 4 verwendet wird.

Der Flachbandleiter 2, dessen einzige gezeigte, mit einer Trägerfolie 11 abgedeckte und durch eine OSP-Schicht (OSP steht für Organische Passivierung (Schichtdicke 0,2...0,5 µm)) gegen Oxidation geschützte Leiterbahn 12 durch einen Lötvorgang mit dem Kontaktstift 1 verbunden werden soll, ist auf der der Vertiefung 7 abgewandten Seite des Kontaktbereiches 4 angeordnet. Derartige Kontaktstifte 1 können mit verschiedenen Typen von Flachbandleitern 2 verbunden werden. Je nach Typ des Flachbandleiters 2 sollte daher die Dicke des Bodens 6 des Hohlkörpers 5 unterschiedlich sein. So sollte die Dicke des Bodens 6 bei einem FPC-Flachbandleiter (FPC steht für Flexible Printed Cable) mit einer Leiterbahndicke von ca. 5 bis 50 µm etwa 50 bis 250 µm betragen. Bei einem FFC-Flachbandleiter (FFC steht für Flexible Flat Cable) mit einer Leiterbahndicke von ca. 100 bis 250 µm sollte die Dicke des Bodens 6 jedoch etwa 500 µm und bei einem FFC-Flachbandleiter mit einer Leiterbahndicke von ca. 250 bis 500 µm etwa 1000 µm betragen.

Die Leiterbahn 12 ist mit einer Ausformung 13 versehen, die derart geformt ist, dass sie in der ersten Phase der Herstellung der Lötverbindung, wie sie in Fig. 1 gezeigt ist, lediglich einen im Wesentlichen punktf6rmigen Kontakt mit dem noch nicht aufgeschmolzenen Lotdepot 9 hat, an das sie mit hier nicht gezeigten Mitteln angedrückt wird. Wesentlich für die Wahl der Gestalt der Ausformung 13 ist dabei die Überlegung, dass zum einen in der Anfangsphase der Herstellung der Lötverbindung, wenn die Ausformung 13 im Wesentlichen punktförmig auf dem Lotdepot aufliegt und über den punktförmigen Kontakt praktisch keine Wärme in die
Ausformung 13 fließt, das Lotdepot 9 sehr rasch aufgeheizt wird, und zum anderen in der Endphase der Herstellung der Lötverbindung, wenn die Ausformung 13 im Wesentlichen punktförmig auf der Kontaktfläche 8 aufliegt, rund um diesen Punkt, der Lötpunktmitte 14, herum ein Ringspalt mit Kapillarwirkung zur Lötpunktmitte 14 ausgebildet wird. Rund um den Fuß der Ausformung 13 herum verläuft ein Randbereich 15, der in den Lötvorgang mit einbezogen ist und durch eine Randzone 16 begrenzt ist, die durch die geometrische Gestalt der Leiterbahn 12 begrenzt ist und in ihrer Größe der Kontaktfläche 8 des Hohlkörpers 5 entsprechen sollte.

In der zweiten Phase der Herstellung der Lötverbindung, wie sie in Fig. 2 gezeigt ist, wird die für den Lötvorgang benötigte Energie mittels eines Laserstrahls 17 durch die Vertiefung 7 hindurch auf den Boden 6 übertragen. Da die Fläche des Bodens 6 nahezu der der Kontaktfläche 8 entspricht, kann durch eine entsprechend großflächige Fokussierung des Laserstrahls 17 die spezifische Flächenbelastung des Bodens 6 gering gehalten und eine gleichmäßige, indirekte Übertragung der Wärme über den Boden 6 in das Lotdepot 9 sichergestellt werden, ohne übermäßigen Wärmeabfluss in die Wand 10 und den Schaft 3 in Kauf nehmen zu müssen. Fig. 2 zeigt eine Situation, in der nach einer kurzzeitigen Erwärmung des Lotdepots 9 über die Schmelztemperatur des Lotes hinaus die Ausformung 13 geringfügig in das geschmolzene Lotdepot 9 einsinkt. Hierbei stellt sich ein zunehmender Flächenkontakt zwischen der Ausformung 13 und der Schmelze ein, der eine schnelle Wärmeübertragung vom Lot an die Leiterbahn 12 ermöglicht. Indem sich diese nach und nach in einem immer umfangreicher werdenden Bereich, der schließlich den Randbereich 15 der Ausformung 13 bis zur Randzone 16 einnimmt, auf die optimale Temperatur erwärmt, verdampft die OSP-Schicht, wodurch der Randbereich aktiviert, d. h. mit geschmolzenem Lot benetzbar wird. Damit die Trägerfolie 11 der Leiterbahn 12 während dieses Vorganges thermisch nicht überlastet wird, wird die Laserleistung soweit reduziert, dass das Lot rasch unter die Schmelztemperatur abkühlt.

Sobald der gesamte Randbereich 15 aktiviert ist, wird die Laserleistung über eine vorgegebene Zeit wieder erhöht, um eine Temperatur wenig oberhalb der Schmelztemperatur einzustellen und das Lotdepot 9 vollständig zu schmelzen. Diese dritte Phase der Herstellung der Baugruppe ist in Fig. 3 gezeigt. Die Ausformung 13 der Leiterbahn 12 ist dabei bis zum punktförmigen Kontakt mit der Kontaktfläche 8 in der Lötpunktmitte 14 an den Hohlkörper 5 gedrückt worden. Bei diesem Vorgang wurde Wärme konzentriert von innen nach außen übertragen und die Lotschmelze langsam nach außen verdrängt. Dabei bildete sich durch die Kapillarwirkung bis hin zur Lötpunktmitte 14 ein umlaufender, konkaver Meniskus 18, der den gesamten aktivierten Randbereich 15 bis zur Randzone 16 umfasst und sicherstellt, dass sich an der Lötstelle keine Mikrorisse ausbilden können.

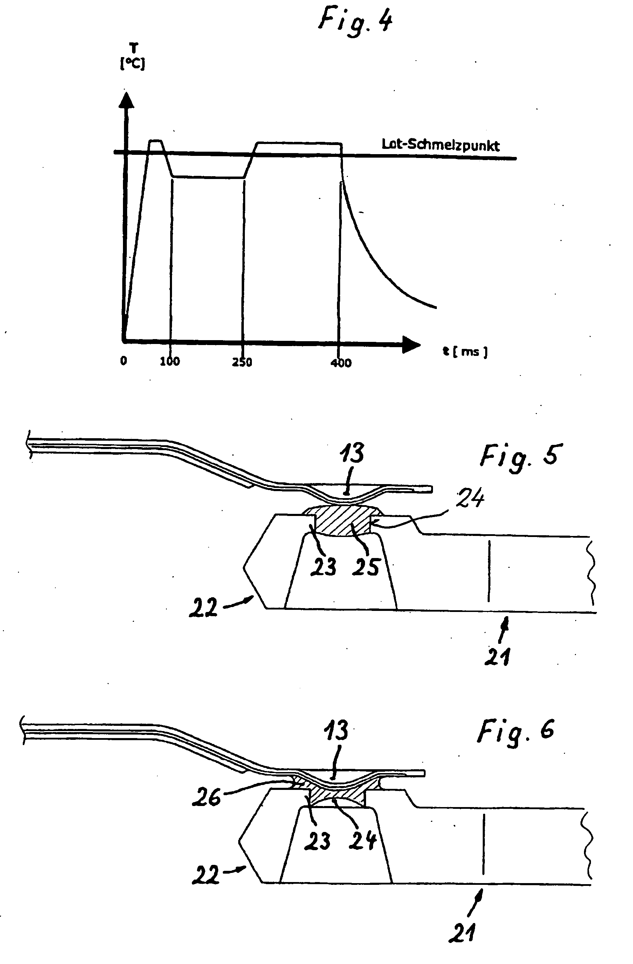

Aus dem Diagramm nach Fig. 4 ist der Verlauf der Temperatur des Lotes ersichtlich, wie er während den aufeinanderfolgenden Schritten des Lötverfahrens zur Herstellung der Baugruppe erforderlich ist. Dabei ist zu beachten, dass die auf der X-Achse eingetragenen Zeitangaben nur Anhaltswerte darstellen. Im Zeitpunkt 0, der sich auf die in Fig. 1 gezeigte Situation bezieht, entspricht die Temperatur des Lotes der Umgebungstemperatur. Nach dem Einschalten des Lasers im Zeitpunkt 0 beginnt die Einstrahlung der Energie und die Temperatur steigt kurzzeitig über die Schmelztemperatur, wobei das Lotdepot 9, wie in Fig. 2 gezeigt, angeschmolzen wird, um einen flächigen Kontakt zwischen der Ausformung 13 und dem Lotdepot 9 zu erzeugen. Infolge der Reduzierung der Leistung des Lasers sinkt die Temperatur bis zum Zeitpunkt 100 dicht unter die Schmelztemperatur, wo bis zum Zeitpunkt 250 ausreichend Zeit für die Aktivierung des Randbereiches 15 zur Verfügung steht. Anschließend, zu Beginn der in Fig. 3 gezeigten Situation, wird die Leistung des Lasers wieder erhöht und die Temperatur dicht oberhalb der Schmelztemperatur eingestellt. Nun wird bis zum Zeitpunkt 400 das Lotdepot 9 vollständig aufgeschmolzen und die Ausformung 13 unter Bildung eines rundum laufenden Meniskus 18 bis auf die Kontaktfläche 8 des Hohlkörpers 5 gedrückt. Nach dem Abschalten des Lasers kühlt die Lötstelle sehr schnell wieder auf Umgebungstemperatur ab.

Fig. 5 zeigt entsprechend Fig. 1 ein weiteres Ausführungsbeispiel der Erfindung. Der im Kontaktbereich des Kontaktstiftes 21 vorgesehene Hohlkörper 22 weist allerdings keinen geschlossenen Boden 23 auf, vielmehr ist dieser mit einer Öffnung 24 versehen, in die ein in Art eines Nietes geformtes Lötdepot 25 eingebracht ist. Die einzelnen Phasen der Herstellung der Lötverbindung entsprechen denen, die in den Fig. 1 bis 3 beschrieben sind. Im Zuge der zu Fig. 3 beschriebenen dritten Phase wird die Ausformung 13 nach Fig. 6 schließlich eine vorgegebene Strecke in das geschmolzene Lot eingedrückt, damit sich der Meniskus 26 in gewünschter Weise ausbildet. Bei diesem Vorgang ist jedoch darauf zu achten, dass die Ausformung 13 nicht mit dem Boden 23 in Kontakt kommt, da hierdurch das Fliessen des geschmolzenen Lotes behindert und die Ausbildung des Meniskus gestört werden könnte.

### Bezugszeichenliste

- 1.: Kontaktstift
- 2.: Flachbandleiter
- 3.: Schaft
- 4.: Kontaktbereich
- 5.: Hohlkörper
- 6.: Boden
- 7.: Vertiefung
- 8.: Kontaktfläche
- 9.: Lotdepot
- 10.: Wand
- 11.: Trägerfolie
- 12.: Leiterbahn
- 13.: Ausformung
- 14.: Lötpunktmitte
- 15.: Randbereich
- 16.: Randzone
- 17.: Laserstrahl
- 18.: Meniskus
- 19.: --
- 20.: --
- 21.: Kontaktstift
- 22.: Hohlkörper
- 23.: Boden
- 24.: Öffnung
- 25.: Lotdepot
- 26.: Meniskus

## Patentansprüche

1. Baugruppe für elektrische/elektronische Geräte, mit mindestens einem elektrisch leitenden Bauteil (1, 21), das in einem Kontaktbereich mittels eines dort durch ein selektives Lötverfahren auf geschmolzenen Lotdepots (9, 25) mit einer Leiterbahn (12) eines Flachbandleiters (2) verbunden ist, wobei die Leiterbahn mit einer Ausformung (13) versehen ist,
**dadurch gekennzeichnet,**
- **dass** das Bauteil insbesondere ein Kontaktstift ist (1, 21), im Kontaktbereich (4) als Hohlkörper (5,22) ausgebildet ist, der einen der Leiterbahn (12) zugewandten Boden (6,23) besitzt, wodurch dieser, bei hinreichender Festigkeit eine minimierte Wärmekapazität auf weist und
- **dass** die Ausformung (13) der Leiterbahn (12) eine sich in Richtung zum Lotdepot (9, 25) verjüngende Ausbildung hat, wodurch vor Beginn des Lötvorganges ein im Wesentlichen punktförmiger Kontakt zwischen der Ausformung (13) und dem Lotdepot (9, 25) vorhanden ist.

2. Baugruppe nach Anspruch 1, **dadurch gekennzeichnet,**
**dass** der Boden (6, 23) des Hohlkörpers (5, 22) eine einen minimalen Energieaufwand für den Lötvorgang ermöglichende Dicke aufweist.

3. Baugruppe nach Anspruch 1, **dadurch gekennzeichnet,**
**dass** der Hohlkörper (5, 22) durch eine Einprägung gebildet ist, die von der der Leiterbahn (12) des Flachbandleiters (2) abgewandten Seite des Bauteils (1, 21) eingebracht ist.

4. Baugruppe nach den Ansprüchen 2 und 3, **dadurch gekennzeichnet,**
**dass** zumindest ein Teil des Bodens (23) durch ein Lotdepot (25) gebildet ist.

5. Baugruppe nach Anspruch 4, **dadurch gekennzeichnet,**
**dass** der Boden (23) mit einer Öffnung (24) versehen ist, der mit dem Lotdepot (25) aufgefüllt ist.

6. Baugruppe nach den Ansprüchen 2 bis 5, **dadurch gekennzeichnet,**
**dass** der Boden (6, 23) des Hohlkörpers (5, 22) eine vom Typ des angelöteten Flachbandleiters (2) abhängige Dicke aufweist, wobei die Dicke des Bodens beträgt:
- bei einem FPC-Flachbandleiter mit einer Leiterbahndicke von ca. 5 bis 50 µm etwa 50 bis 250 µm,
- bei einem FFC- Flachbandleiter mit einer Leiterbahndicke von ca. 100 bis 250 µm etwa 500 µm und
- bei einem FFC- Flachbandleiter mit einer Leiterbahndicke von ca. 250 bis 500 µm etwa 1000 µm.

7. Baugruppe nach den Ansprüchen 2 bis 6, **dadurch gekennzeichnet,**
**dass** die Dicke der Wand (10) des Hohlkörpers (5, 22) zumindest annähernd der Dicke des Bodens (6, 23) entspricht.

8. Baugruppe nach Anspruch 1, **dadurch gekennzeichnet,**
**dass** die Ausformung (13) der Leiterbahn (12) eine kegel- oder kugelkalottenförmige Gestalt besitzt.

9. Baugruppe nach mindestens einem der Ansprüche 1 bis 8,
**dadurch gekennzeichnet,**
- **dass** rund um den Fuß der Ausformung (13) ein Randbereich (15) verläuft, der in den Lötvorgang mit einbezogen ist und durch eine Randzone (16) begrenzt ist, die durch die geometrische Gestalt der Leiterbahn (12) begrenzt ist und in ihrer Größe ungefähr der Kontaktfläche (8) des Hohlkörpers (5) entspricht,
- und **dass** bis hin zur Lötpunktmitte (14) ein umlaufender, konkaver Meniskus (18), der den gesamten aktivierten Randbereich (15) bis zur Randzone (16) umfasst.

10. Lötverfahren zur Herstellung einer Baugruppe nach den Ansprüchen 1 bis 9,
**gekennzeichnet durch**
folgende Verfahrensschritte:
a) Andrücken der Ausformung (13) der Leiterbahn (12) an das nicht aufgeschmolzene Lotdepot (9, 25) mit punktförmigem Kontakt zwischen der Ausformung (13) und dem Lotdepot (9, 25),
b) kurzzeitige Zuführung von Wärmeenergie zum Lotdepot (9, 25) über den Boden (6, 23) des Hohlkörpers (5, 22) in einer zum Anschmelzen des Lotdepots (9, 25) und Ausbilden eines flächigen Kontakts zwischen der Ausformung (13) und dem Lotdepot (9, 25) ausreichenden Höhe,
c) bei - zwecks konstant Halten des flächigen Kontakts - reduzierter Wärmezufuhr Erwärmung eines dem Lotdepot (9, 25) gegenüberliegenden Bereiches der Leiterbahn (12) auf eine Temperatur, die geringfügig unterhalb der Schmelztemperatur des Lotes liegt, um deren mit dem aufgeschmolzenen Lot in Kontakt kommende Fläche (15) für das Benetzen mit dem Lot vorzubereiten und
d) Erwärmung des Lotdepots (9, 25) geringfügig oberhalb der Schmelztemperatur mit Einsinken der Ausformung (13) bis zum Kontakt mit der Kontaktfläche (8) des Hohlkörpers (5) oder zu einer vorgegebenen Einsenktiefe und Ausbildung eines umlaufenden Meniskus (18, 26) an der vorbereiteten Oberfläche der Leiterbahn (12) **durch** das verdrängte flüssige Lot bis hin zur begrenzten Randzone (16).

11. Lötverfahren nach Anspruch 10, **dadurch gekennzeichnet,**
**dass** die für den Lötvorgang benötigte Wärmeenergie von einem Laser geliefert wird.

## Claims

1. Module for electrical/electronic devices, with at least one electrically conducting component (1, 21) which in a contact area is connected to a conductor track (12) of a ribbon conductor (2) by means of a solder deposit (9, 25) fused in place there by a selective soldering method, the conductor track being provided with a bulge (13),
**characterised in that**
- the component is in particular a contact pin (1, 21), embodied in the contact area (4) as a hollow body (5, 22) which has a bottom (6, 23) which faces the conductor track (12) so that it exhibits a minimised thermal capacity with adequate strength and
- the bulge (13) of the conductor track (12) has a shape which tapers in the direction of the solder deposit (9, 25), so that before the start of the soldering operation essentially punctiform contact is present between the bulge (13) and the solder deposit (9, 25).

2. Module according to claim 1, **characterised in that** the bottom (6, 23) of the hollow body (5, 22) exhibits a thickness allowing minimal energy consumption for the soldering operation.

3. Module according to claim 1, **characterised in that** the hollow body (5, 22) is formed by an impression applied from the side of the component (1, 21) facing away from the conductor track (12) of the ribbon conductor (2).

4. Module according to claims 2 and 3, **characterised in that** at least a part of the bottom (23) is formed by a solder deposit (25).

5. Module according to claim 4, **characterised in that** the bottom (23) is provided with an opening (24) which is filled with the solder deposit (25).

6. Module according to claims 2 to 5, **characterised in that** the bottom (6, 23) of the hollow body (5, 22) exhibits a thickness depending on the type of soldered ribbon connector (2), the thickness of the bottom being:
- approximately 50 to 250 µm in the case of an FPC ribbon conductor with a conductor track thickness of approx. 5 to 50 µm,
- approximately 500 µm in the case of an FFC ribbon conductor with a conductor track thickness of approx. 100 to 250 µm, and
- approximately 1000 µm in the case of an FFC ribbon conductor with a conductor track thickness of approx. 250 to 500 µm.

7. Module according to claims 2 to 6, **characterised in that** the thickness of the wall (10) of the hollow body (5, 22) is at least approximately the same as the thickness of the bottom (6, 23).

8. Module according to claim 1, **characterised in that** the bulge (13) of the conductor track (12) has a conical or spherical domed shape.

9. Module according to at least one of claims 1 to 8,
**characterised in that**
- running around the foot of the bulge (13) there is an edge area (15) which is included in the soldering operation and bounded by an edge zone (16) which is bounded by the geometric shape of the conductor track (12) and in its size roughly corresponds to the contact area (8) of the hollow body(5),
- and **in that** running to the middle (14) of the solder point there is a circumferential concave meniscus (18) which covers the entire activated edge area (15) to the edge zone (16).

10. Soldering method for manufacturing a module according to claims 1 to 9, **characterised by** the following process steps:
a) pressing of the bulge (13) of the conductor track (12) against the unfused solder deposit (9, 25) with punctiform contact between the bulge (13) and the solder deposit (9, 25),
b) brief application of thermal energy to the solder deposit (9, 25) through the bottom (6, 23) of the hollow body (5, 22) to a level sufficient to melt the solder deposit (9, 25) and form an areal contact between the bulge (13) and the solder deposit (9, 25),
c) during reduced application of heat to keep the areal contact constant, heating of an area of the conductor track (12) facing the solder deposit (9, 25) to a temperature which is slightly below the melting temperature of the solder in order to prepare its area (15) coming into contact with the fused solder for wetting with the solder and
d) heating of the solder deposit (9, 25) slightly above the melting temperature with sinking of the bulge (13) into contact with the contact area (8) of the hollow body (5) or to a predetermined sinking depth and formation of a surrounding meniscus (18, 26) on the prepared surface of the conductor track (12) by the displaced liquid solder extending to the bounded edge zone (16).

11. Soldering method according to claim 10, **characterised in that** the thermal energy required for the soldering operation is supplied by a laser.

## Revendications

1. Module pour des appareils électriques/électroniques comprenant au moins un composant (1, 21) conducteur de l'électricité, qui est relié à une piste (12) conductrice d'un conducteur (2) en ruban plat dans une partie de contact au moyen d'un dépôt (9, 25) de brasure fondu, qui est déposé par un procédé de brasure sélectif, la piste conductrice étant munie d'une excroissance (13),
**caractérisé**
- **en ce que** le composant est notamment une broche de contact (1, 21) et constitué dans la partie (4) de contact sous la forme d'une pièce (5, 22) creuse qui a un fond (6, 23) tourné vers la piste (12) conductrice, ce fond ayant ainsi une capacité calorifique minimisée, tout en ayant une solidité suffisante et
- **en ce que** l'excroissance (13) de la piste (12) conductrice a une constitution se rétrécissant dans la direction du dépôt (9, 25) de brasure de sorte qu'il y a, avant le début de l'opération de brasure, un contact sensiblement ponctuel entre l'excroissance (13) et le dépôt (9, 25) de brasure.

2. Module suivant la revendication 1, **caractérisé en ce que** le fond (6, 23) de la pièce (5, 22) creuse a une épaisseur permettant d'avoir une dépense minimum d'énergie pour l'opération de brasure.

3. Module suivant la revendication 1, **caractérisé en ce que** la pièce (5, 22) creuse est formée en ménageant une empreinte par le côté du composant (1, 21) éloigné de la piste (12) conductrice du conducteur (2) en ruban plat.

4. Module suivant les revendications 2 et 3, **caractérisé en ce qu'**au moins une partie du fond (23) est formée par un dépôt (25) de brasure.

5. Module suivant la revendication 4, **caractérisé en ce que** le fond (23) est muni d'une ouverture (24) qui est remplie par le dépôt (25) de brasure.

6. Module suivant les revendications 2 à 5, **caractérisé en ce que** le fond (6, 23) de la pièce (5, 22) creuse a une épaisseur qui dépend du type du conducteur (2) en ruban plat brasé, l'épaisseur du fond étant :
- pour un conducteur en ruban plat FPC avec une épaisseur de piste conductrice d'environ 5 à 50 µm, d'environ 50 à 250 µm,
- pour un conducteur en ruban plat FFC avec une épaisseur de piste conductrice d'environ 100 à 250 µm, d'environ 500 µm, et
- pour un conducteur en ruban plat FFC avec une épaisseur de piste conductrice d'environ 250 à 500 µm, d'environ 1 000 µm.

7. Module suivant les revendications 2 à 6, **caractérisé en ce que** l'épaisseur de la paroi (10) de la pièce (5, 22) creuse correspond au moins à peu près à l'épaisseur du fond (6, 23).

8. Module suivant la revendication 1, **caractérisé en ce que** l'excroissance (13) de la piste (12) conductrice a la forme d'une calotte conique ou d'une calotte sphérique.

9. Module suivant l'une au moins des revendications 1 à 8,
**caractérisé**
- **en ce que**, autour du pied de l'excroissance (13), s'étend une partie (15) de bord, qui est incluse dans l'opération de brasure et qui est délimitée par une zone (16) de bord, qui est délimitée par la forme géométrique de la piste (12) conductrice et dont la dimension correspond à peu près à la surface (8) de contact de la pièce (5) creuse,
- et **en ce que**, jusqu'au centre (14) de la brasure, un ménisque (18) concave faisant le tour entoure jusqu'à la zone (16) de bord toute la partie (15) de bord activée.

10. Procédé de brasure pour la fabrication d'un module suivant l'une des revendications 1 à 9,
**caractérisé**
**par** les stades de procédé suivants :
a) on presse l'excroissance (13) de la piste (2) conductrice sur le dépôt (9, 25) de brasure qui n'est pas encore fondu, en ayant un contact ponctuel entre l'excroissance (13) et le dépôt (9, 25) de brasure,
b) on apporte brièvement de l'énergie calorifique au dépôt (9, 25) de brasure par le fond (6, 23) de la pièce (5, 22) creuse à un niveau suffisant pour faire fondre le dépôt (9, 25) de brasure et former un contact superficiel entre l'excroissance (13) et le dépôt (9, 25) de brasure,
c) par un apport de chaleur réduit, en vue de maintenir constamment le contact superficiel, on porte une partie de la piste (12) conductrice opposée au dépôt (9, 25) de brasure à une température qui est légèrement inférieure au point de fusion de la brasure pour préparer au mouillage par la brasure sa surface (15) venant en contact avec la brasure fondue et
d) on porte le dépôt (9, 25) de brasure légèrement au-dessus du point de fusion avec enfoncement de l'excroissance (13) jusqu'au contact avec la surface (8) de contact de la pièce (5) creuse ou jusqu'à une profondeur d'enfoncement prescrite et on forme un ménisque (18, 26) faisant le tour sur la surface préparée de la piste (12) conductrice par la brasure liquide refoulée jusqu'à la zone (16) de bord délimitée.

11. Procédé de brasure suivant la revendication 10,
**caractérisé en ce que** l'on fournit par un laser l'énergie calorifique nécessaire à l'opération de brasure.
